# EUROPÄISCHE PATENTANMELDUNG

(11) **EP 4 531 234 A1**
(43) Veröffentlichungstag der Anmeldung: **02.04.2025**
(21) Anmeldenummer: 24186494.1
(22) Anmeldetag: 04.07.2024
(51) Int. Cl.: H02J 7/00, G01R 31/382, H01M 10/44, B60L 53/00, B60L 58/12

(54) **VERFAHREN UND VORRICHTUNG ZUM LADEN ODER ENTLADEN EINES BATTERIESYSTEMS**

(30) Priorität: 07.08.2023 DE 102023207541
(71) Anmelder: VOLKSWAGEN AG, 38440 Wolfsburg (DE)
(72) Erfinder: Bedürftig, Benjamin, 89077 Ulm (DE); Rumberg, Björn, 38302 Wolfenbüttel (DE); Klein, Tobias, 38304 Wolfenbüttel (DE)

(57) **Zusammenfassung**

Die Erfindung betrifft ein Verfahren zum Laden oder Entladen eines Batteriesystems (20), wobei das Batteriesystem (20) mindestens zwei parallel und/oder in Reihe geschaltete Batteriezellen (21-x) aufweist, welche nur gemeinsam geladen oder entladen werden können, wobei eine Spannung (U) als Regelgröße mittels eines Stroms (I) oder einer Leistung (P) als Stellgröße geregelt wird, wobei hierbei der Strom (I) oder die Leistung (P) unter Berücksichtigung von einer ersten ladezustandsabhängigen Kennlinie (3-1) und einer zweiten ladezustandsabhängigen Kennlinie (3-2) vorgegeben wird, und wobei die erste ladezustandsabhängige Kennlinie (3-1) und die zweite ladezustandsabhängige Kennlinie (3-2) zumindest abschnittsweise entgegengesetzte Steigungen aufweisen. Ferner betrifft die Erfindung eine Vorrichtung (1) zum Laden oder Entladen eines Batteriesystems (20).

## Beschreibung

Die Erfindung betrifft ein Verfahren und eine Vorrichtung zum Laden oder Entladen eines Batteriesystems.

Li-lonen-Zellen können je nach Temperatur, Bestromungsdauer und Ladezustand nur einen begrenzten Ladestrom aufnehmen, ohne Schaden zu nehmen. Dieser maximale Strom ändert sich zudem mit einem Alterungszustand (SOH) der Li-lonen-Zellen. Weiterhin ergibt sich die Schwierigkeit, dass in einem Batteriesystem mehrere Zellen in Serie oder parallel geschaltet sein können und die Zellen unterschiedliche Temperaturen und/oder Alterungszustände und/oder Ladezustände aufweisen können. Folglich ist es derzeit notwendig, zu jedem Zeitpunkt den Lade- und Alterungszustand aller Zellen im System, sowie die kälteste und wärmste Stelle zu kennen. Das schließt auch ein, dass Temperaturgradienten innerhalb einer Zelle bekannt sein müssen, um tatsächlich den kältesten und wärmsten Punkt im gesamten Batteriesystem zu kennen. Diese beiden Punkte bestimmen zusammen mit dem Lade- und Alterungszustand einer jeden Zelle den zu jedem Zeitpunkt maximal möglichen Ladestrom. Da eine ausrelaxierte Zelle kurzfristig einen höheren Strom als den maximal möglichen Dauerstrom aufnehmen kann, muss zudem die zeitliche Reaktion der Zelle auf den Ladestrom bekannt sein. Zudem sind die maximal zulässigen Ladeströme auch von einem mechanischen Druck bzw. einer Kraft, welche/r auf die Batteriezellen wirkt, abhängig. Weiter kann eine Ladezustandsverteilung, das heißt, unterschiedliche Ladezustände, innerhalb des Batteriesystems zwischen den einzelnen Batteriezellen auftreten. Zudem kann es auch innerhalb einer Batteriezelle zu einer Ladezustandsverteilung kommen. Diese Ladezustandsverteilung muss bei der Wahl (Regelung) des Ladestromes berücksichtig werden, da der Ladestrom in der Regel vom Ladezustand abhängt. Das Bestimmen des Ladezustands jeder Einzelzelle bei parallel geschalteten Batteriezellen sowie der Ladezustandsverteilung innerhalb einer Batteriezelle können im praktischen Betrieb jedoch technisch nicht sinnvoll umgesetzt werden.

Aus der DE 10 2021 108 085 A1 ist ein Verfahren zum Bestimmen von mindestens einem Steuerparameter für eine Ladeeinrichtung zum Zuführen von elektrischer Ladung zu einem lithiumbasierten elektrischen Energiespeicher bekannt, zu welchem Zweck der elektrische Energiespeicher abhängig von mindestens einem Zustandsparameter des elektrischen Energiespeichers mit einem elektrischen Ladestrom beaufschlagt wird. Es wird zum Bestimmen des mindestens einen Steuerparameters eine Grenzfunktion, durch die einer zugeführten elektrischen Ladungsmenge eine elektrische Grenzspannung zugeordnet wird, derart ermittelt, dass ein Anodenpotential größer als ein vorgegebener Anodenpotentialwert ist, wenn eine Anschlussspannung kleiner als die Grenzspannung ist, wobei der vorgegebene Anodenpotentialwert größer als null Volt gegenüber einer Li/Li+-Bezugselektrode ist.

Der Erfindung liegt die Aufgabe zu Grunde, ein Verfahren und eine Vorrichtung zum Laden oder Entladen eines Batteriesystems zu verbessern.

Die Aufgabe wird erfindungsgemäß durch ein Verfahren mit den Merkmalen des Patentanspruchs 1 und eine Vorrichtung mit den Merkmalen des Patentanspruchs 10 gelöst. Ferner wird die Aufgabe durch ein Verfahren mit den Merkmalen des Patentanspruchs 11 und eine Vorrichtung mit den Merkmalen des Patentanspruchs 12 gelöst. Vorteilhafte Ausgestaltungen der Erfindung ergeben sich aus den Unteransprüchen.

Insbesondere wird ein Verfahren zum Laden oder Entladen eines Batteriesystems zur Verfügung gestellt, wobei das Batteriesystem mindestens zwei parallel und/oder in Reihe geschaltete Batteriezellen aufweist, welche nur gemeinsam geladen oder entladen werden können, wobei eine Spannung als Regelgröße mittels eines Stroms oder einer Leistung als Stellgröße geregelt wird, wobei hierbei der Strom oder die Leistung unter Berücksichtigung von einer ersten ladezustandsabhängigen Kennlinie und einer zweiten ladezustandsabhängigen Kennlinie vorgegeben wird, und wobei die erste ladezustandsabhängige Kennlinie und die zweite ladezustandsabhängige Kennlinie zumindest abschnittsweise entgegengesetzte Steigungen aufweisen.

Ferner wird insbesondere eine Vorrichtung zum Laden oder Entladen eines Batteriesystems geschaffen, wobei das Batteriesystem mindestens zwei parallel und/oder in Reihe geschaltete Batteriezellen aufweist, welche nur gemeinsam geladen oder entladen werden können, umfassend einen Regler, wobei der Regler dazu eingerichtet ist, eine Spannung als Regelgröße mittels eines Stroms oder einer Leistung als Stellgröße zu regeln, wobei hierbei der Strom oder die Leistung unter Berücksichtigung von einer ersten ladezustandsabhängigen Kennlinie und einer zweiten ladezustandsabhängigen Kennlinie vorgegeben wird, und wobei die erste ladezustandsabhängige Kennlinie und die zweite ladezustandsabhängige Kennlinie zumindest abschnittsweise entgegengesetzte Steigungen aufweisen.

Weiter wird insbesondere ein Verfahren zum Laden oder Entladen eines Batteriesystems zur Verfügung gestellt, wobei das Batteriesystem eine Batteriezelle aufweist, wobei eine Spannung als Regelgröße mittels eines Stroms oder einer Leistung als Stellgröße geregelt wird, wobei hierbei der Strom oder die Leistung unter Berücksichtigung von einer ersten ladezustandsabhängigen Kennlinie und einer zweiten ladezustandsabhängigen Kennlinie vorgegeben wird, und wobei die erste ladezustandsabhängige Kennlinie und die zweite ladezustandsabhängige Kennlinie zumindest abschnittsweise entgegengesetzte Steigungen aufweisen.

Es wird auch eine Vorrichtung zum Laden oder Entladen eines Batteriesystems geschaffen, wobei das Batteriesystem eine Batteriezelle aufweist, umfassend einen Regler, wobei der Regler dazu eingerichtet ist, eine Spannung als Regelgröße mittels eines Stroms oder einer Leistung als Stellgröße zu regeln, wobei hierbei der Strom oder die Leistung unter Berücksichtigung von einer ersten ladezustandsabhängigen Kennlinie und einer zweiten ladezustandsabhängigen Kennlinie vorgegeben wird, und wobei die erste ladezustandsabhängige Kennlinie und die zweite ladezustandsabhängige Kennlinie zumindest abschnittsweise entgegengesetzte Steigungen aufweisen.

Das Verfahren und die Vorrichtung ermöglichen es, ein Laden oder Entladen ausgehend von einem Ladezustand des Batteriesystems als Gesamtsystem zu regeln, insbesondere ohne dass hierfür die Zustände der einzelnen Batteriezellen bekannt sein müssen. Eine der Grundideen ist hierbei, zwei ladezustandsabhängige Kennlinien zum Regeln zu verwenden, wobei diese beiden Kennlinien zumindest abschnittsweise eine entgegengesetzte Steigung aufweisen. Dies ermöglicht es, Grenzwerte für elektrische Größen beim Laden und Entladen einzuhalten, insbesondere wenn eine Schätzung des Ladezustands mit einem Fehler behaftet ist.

Eine Spannung, ein Strom, ein Innenwiderstand und eine Leistung beim Laden und Entladen sind insbesondere eine Gesamtspannung, ein Gesamtstrom, ein Gesamtinnenwiderstand und eine Gesamtleistung des Batteriesystems. Die Größen für die einzelnen Batteriezellen werden insbesondere nicht erfasst und/oder verwendet.

Es ist insbesondere vorgesehen, dass eine Spannung an dem Batteriesystem erfasst wird, wobei diese Spannung als Regelgröße beim Regeln verwendet wird.

Es ist insbesondere vorgesehen, dass die Kennlinien Maximalwerte (Grenzwerte) für geeignete elektrische Größen vorgeben, die nicht überschritten werden dürfen. Durch das Verwenden von zwei Kennlinien können zwei solcher Größen berücksichtigt und/oder gemäß diesem Verfahren zum Regeln verwendet werden. Es kann hierbei vorgesehen sein, dass beim Regeln erst das Einhalten der ersten Kennlinie überprüft wird und anschließend das Einhalten der zweiten Kennlinie. Es kann hierbei jedoch alternativ auch vorgesehen sein, dass beim Regeln erst das Einhalten der zweiten Kennlinie überprüft wird und anschließend das Einhalten der ersten Kennlinie. Ferner kann das Überprüfen des Einhaltens beider Kennlinien auch gleichzeitig erfolgen.

Die erste ladezustandsabhängige Kennlinie und die zweite ladezustandsabhängige Kennlinie werden insbesondere unter Laborbedingungen, insbesondere in empirischen Versuchen, und/oder mit Hilfe von Simulationen bestimmt. Hierdurch kann beispielsweise eine Kennlinie für eine ladezustandsabhängige Maximalspannung bestimmt werden. Beispielsweise können hierzu Messungen an 3-Elektrodenlaborzellen erfolgen. Ferner können auch Druckkraft-, Dicken- oder High Precision Coulombmetry-Messungen erfolgen. Weiter kann auch ein vorgegebenes Stromkennfeld, insbesondere auch unter Berücksichtigung einer Sicherheitsmarge, auf die Zelle angewendet werden und auf diese Weise eine ladezustandsabhängige Kennlinie für die Maximalspannung bestimmt werden. Eine Simulation kann beispielsweise auf Basis von Halbzellmodellen erfolgen.

Teile der Vorrichtung, insbesondere der Regler, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

In einer Ausführungsform ist vorgesehen, dass die Kennlinien über alle Ladezustände hinweg entgegengesetzte Steigungen aufweisen. Hierdurch kann eine besonders einfache Umsetzung des Verfahrens und der Vorrichtung bereitgestellt werden und zu jeder Zeit das Einhalten von Grenzwerten sichergestellt werden.

In einer Ausführungsform ist vorgesehen, dass die erste ladezustandsabhängige Kennlinie eine mit dem Ladezustand ansteigende Maximalspannung beim Laden oder Entladen vorgibt. Hierdurch kann eine Spannung beim Laden und Entladen begrenzt werden. Dem liegt der Gedanke zugrunde, dass wenn der maximale Lade- oder Entladestrom für jeden Ladezustand bestimmt wird und die Annahme getroffen wird, dass das Anodenpotential der limitierende Faktor ist, eine von der Temperatur unabhängige ladezustandsabhängige Vollzellspannungstrajektorie resultiert. Insbesondere diese Vollzellspannungstrajektorie bildet dann die ladezustandsabhängige erste Kennlinie. Diese Vollzellspannungstrajektorie steigt mit ansteigendem Ladezustand.

In einer Ausführungsform ist vorgesehen, dass die erste ladezustandsabhängige Kennlinie einen mit dem Ladezustand ansteigenden maximalen Innenwiderstand beim Laden oder Entladen vorgibt. Der Innenwiderstand kann hierbei anhand eines Stromes und einer Überspannung (= Außenspannung, das heißt einer Spannung unter Last, abzüglich der Leerlaufspannung) berechnet werden. Die Überspannung kann hierbei in an sich bekannter Weise aus einem Modell geschätzt werden.

In einer Ausführungsform ist vorgesehen, dass die zweite ladezustandsabhängige Kennlinie einen mit dem Ladezustand fallenden maximalen Strom beim Laden oder Entladen vorgibt. Hierdurch kann ein Strom beim Laden und Entladen begrenzt werden.

In einer Ausführungsform ist vorgesehen, dass die zweite ladezustandsabhängige Kennlinie eine mit dem Ladezustand fallende maximale Leistung beim Laden oder Entladen vorgibt. Hierdurch kann eine Leistung beim Laden oder Entladen begrenzt werden. Die Leistung kann hierbei eine aus dem Strom und der Spannung berechnete Leistung sein (d.h. P = U*I; mit P der Leistung, U der Spannung und I dem Strom). Grundsätzlich kann die Leistung aber auch eine Verlustleistung sein, welche sich beispielsweise aus dem Innenwiderstand und dem Strom (d.h. P =R*I²) oder aus der Überspannung und dem Strom (d.h. P = U_{Ü}*I) berechnet.

Es kann auch vorgesehen sein, dass die erste ladezustandsabhängige Kennlinie und/oder die zweite ladezustandsabhängige Kennlinie eine Kombination aus elektrischen Größen abbildet und/oder Grenzwerte für eine derartige Kombination der elektrischen Größen vorgibt.

In einer Ausführungsform ist vorgesehen, dass eine Temperatur des Batteriesystems erfasst und/oder geschätzt wird, wobei die erste ladezustandsabhängige Kennlinie und/oder die zweite ladezustandsabhängige Kennlinie temperaturabhängig sind, wobei die erfasste und/oder geschätzte Temperatur berücksichtigt wird. Hierdurch können Temperatureffekte berücksichtigt werden, sodass eine Regelung beim Laden oder Entladen weiter verbessert werden kann.

In einer Ausführungsform ist vorgesehen, dass ein Ladezustand des Batteriesystems ausgehend von einer zeitlichen Integration des Stromes beim Laden oder Entladen geschätzt wird. Hierzu integriert ein Ladezustands-Schätzer einen beim Laden oder Entladen fließenden Strom auf. Dies liefert bilanziert eine Ladungsmenge, die in das Batteriesystem hineingeflossen und/oder aus diesem hinausgeflossen ist. Ausgehend von einem Startwert und einer Gesamtladungsmenge, die das Batteriesystem speichern kann, kann auf diese Weise der aktuelle Ladezustand bestimmt werden. Der Ladezustand (engl. state of charge, SOC) kann beispielsweise mit Bezug auf eine maximal speicherbare Ladungsmenge als Prozentzahl oder absolut in der Einheit Amperestunden (Ah) angegeben werden.

In einer Ausführungsform ist vorgesehen, dass ein Ladezustand des Batteriesystems ausgehend von einer Leerlaufspannungs-Ladezustands-(OCV/SOC)-Kennlinie und/oder mittels eines elektrischen Batteriemodells geschätzt wird. Die Leerlaufspannungs-Ladezustands-(OCV/SOC)-Kennlinie ermöglicht es, anhand einer Messung der Leerlaufspannung im nichtbelasteten Zustand des Batteriesystems den Ladezustand zu schätzen. Das elektrische Batteriemodell erlaubt es, in an sich bekannter Weise anhand von messbaren elektrischen Größen (Leerlaufspannung, Spannung, Strom, Innenwiderstand etc.) einen Ladezustand zu schätzen. Die Leerlaufspannungs-Ladezustands-(OCV/SOC)-Kennlinie und/oder das elektrische Batteriemodell werden beispielsweise mit Hilfe von Messungen unter Laborbedingungen, das heißt mittels empirischer Versuche, und/oder mit Hilfe von Simulationen bestimmt.

Weitere Merkmale zur Ausgestaltung der Vorrichtungen ergeben sich aus der Beschreibung von Ausgestaltungen des Verfahrens. Die Vorteile der Vorrichtungen sind hierbei jeweils die gleichen wie bei den Ausgestaltungen des Verfahrens. Die Ausführungsformen des Verfahrens und der Vorrichtung zum Laden und Entladen eines Batteriesystem mit nur einer Batteriezelle sind hierbei insbesondere die gleichen wie für ein Batteriesystem mit mehreren Batteriezellen.

Nachfolgend wird die Erfindung anhand bevorzugter Ausführungsbeispiele unter Bezugnahme auf die Figuren näher erläutert. Hierbei zeigen:
- Fig. 1: eine schematische Darstellung einer Ausführungsform der Vorrichtung zum Laden oder Entladen eines Batteriesystems;
- Fig. 2a, 2b, 2c: schematische Darstellungen zur Verdeutlichung der Funktionsweise einer Ausführungsform des Verfahrens und der Vorrichtung;
- Fig. 3: Ergebnisse eines simulierten Ladevorgangs an einem Batteriesystem mit zwei parallel geschalteten Batteriezellen und einer verfahrensgemäßen Regelung.

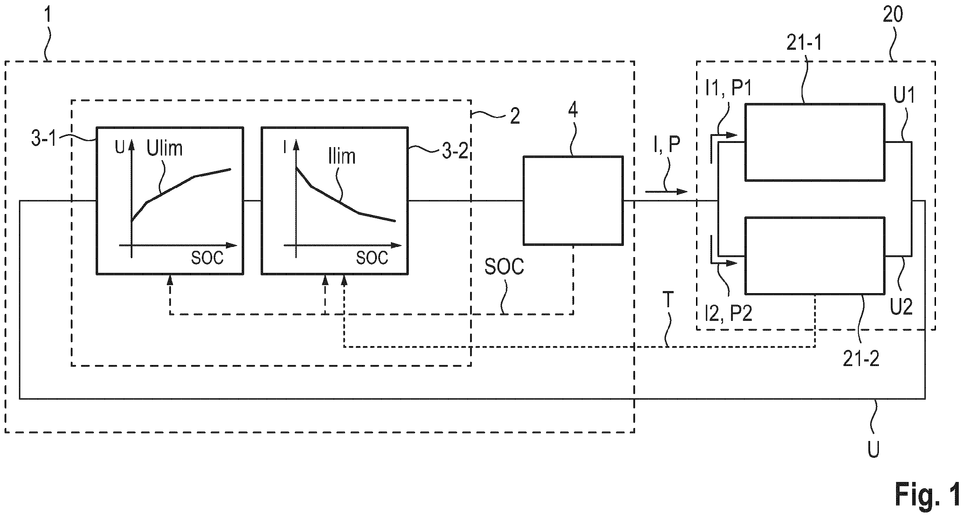

Die Fig. 1 zeigt eine schematische Darstellung einer Ausführungsform der Vorrichtung 1 zum Laden oder Entladen eines Batteriesystems 20. Das Batteriesystem 20 umfasst zwei parallel geschaltete Batteriezellen 21-x (alternativ auch in einer anderen Verschaltung), welche jedoch nur gemeinsam geladen und entladen werden können. Die Batteriezellen 21-x sind insbesondere Li-lonenzellen. Eine Vorrichtung zum Laden und Entladen eines Batteriesystems mit nur einer Batteriezelle ist grundsätzlich auf die gleiche Weise ausgestaltet wie die in der Fig. 1 gezeigte Ausführungsform, sodass nicht gesondert hierauf eingegangen wird.

Die Vorrichtung 1 umfasst einen Regler 2. Der Regler 2 ist dazu eingerichtet, eine sich aus den Spannungen U1, U2 an den Batteriezellen 3-x zusammensetzende (Gesamt-)Spannung U als Regelgröße mittels eines Stroms I oder einer Leistung P als Stellgröße zu regeln. Der Strom I bzw. die Leistung P teilt sich auf die Ströme I1, I2 bzw. die Leistungen P1, P2 an den einzelnen Batteriezellen 21-x auf. Die Spannung U und der Strom I bzw. die Leistung P beziehen sich hierbei auf das Batteriesystem 20 als Gesamtsystem, das heißt, die entsprechenden Werte für die einzelnen Batteriezellen 21-x sind nicht bekannt und werden auch nicht erfasst. Die Spannung U wird am Batteriesystem 20 mittels einer hierfür eingerichteten Sensorik (nicht gezeigt) erfasst.

Es ist vorgesehen, dass der Strom I oder die Leistung P beim Regeln unter Berücksichtigung von einer ersten ladezustandsabhängigen Kennlinie 3-1 und einer zweiten ladezustandsabhängigen Kennlinie 3-2 vorgegeben wird. Die erste ladezustandsabhängige Kennlinie 3-1 und die zweite ladezustandsabhängige Kennlinie 3-2 weisen zumindest abschnittsweise eine entgegengesetzte Steigung auf. Die Regelung erfolgt insbesondere derart, dass durch die Kennlinien 3-x vorgegebene maximale Werte (Grenzwerte) nicht überschritten werden.

Ein Ladezustand SOC wird mittels eines Ladezustands-Schätzers 4 der Vorrichtung 1 geschätzt. Es kann vorgesehen sein, dass der Ladezustand SOC des Batteriesystems 20 ausgehend von einer zeitlichen Integration des Stromes I beim Laden oder Entladen geschätzt wird. Alternativ oder zusätzlich kann vorgesehen sein, dass der Ladezustand SOC des Batteriesystems 20 ausgehend von einer Leerlaufspannungs-Ladezustands-(OCV/SOC)-Kennlinie und/oder mittels eines elektrischen Batteriemodells geschätzt wird.

Im gezeigten Beispiel ist insbesondere vorgesehen, dass die erste ladezustandsabhängige Kennlinie 3-1 eine mit dem Ladezustand SOC ansteigende maximale Spannung Ulim beim Laden oder Entladen vorgibt.

Ferner ist im gezeigten Beispiel ferner insbesondere vorgesehen, dass die zweite ladezustandsabhängige Kennlinie 3-2 einen mit dem Ladezustand SOC fallenden maximalen Strom Ilim beim Laden oder Entladen vorgibt.

Es ist im gezeigten Beispiel insbesondere vorgesehen, dass die Kennlinien 3-1, 3-2 über alle Ladezustände SOC hinweg entgegengesetzte Steigungen aufweisen.

Es kann alternativ vorgesehen sein, dass die erste ladezustandsabhängige Kennlinie 3-1 einen mit dem Ladezustand SOC ansteigenden maximalen Innenwiderstand beim Laden oder Entladen vorgibt.

Alternativ kann alternativ vorgesehen sein, dass die zweite ladezustandsabhängige Kennlinie 3-2 eine mit dem Ladezustand SOC fallende maximale Leistung beim Laden oder Entladen vorgibt.

Es kann vorgesehen sein, dass eine Temperatur T des Batteriesystems 20 erfasst und/oder geschätzt wird, wobei die erste ladezustandsabhängige Kennlinie 3-1 und/oder die zweite ladezustandsabhängige Kennlinie 3-2 temperaturabhängig sind, und wobei die erfasste und/oder geschätzte Temperatur T berücksichtigt wird. Es kann beispielsweise vorgesehen sein, dass die Kennlinien 3-x ausgehend von der erfassten und/oder geschätzten Temperatur T ausgewählt oder parametriert werden.

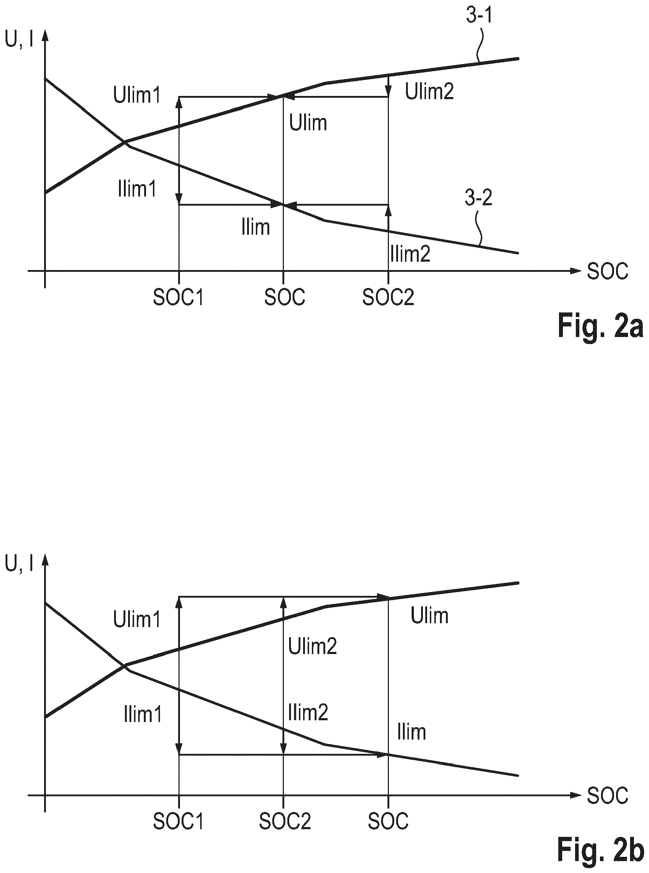

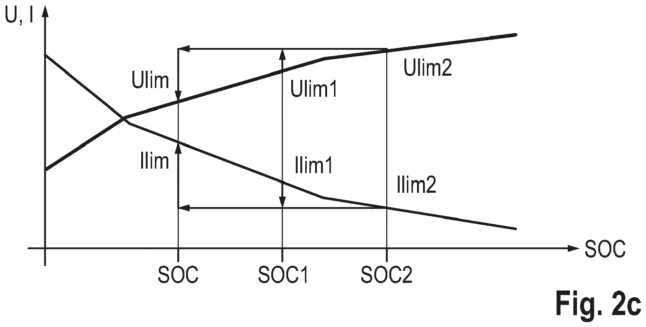

Die Figuren 2a, 2b und 2c zeigen schematische Darstellungen zur Verdeutlichung der Funktionsweise einer Ausführungsform des Verfahrens und der Vorrichtung. Jede der drei Figuren zeigt einen spezifischen Fall von Ladezuständen zu einem einzigen Zeitpunkt.

In der Fig. 2a schätzt der Ladezustands-Schätzer 4 einen Ladezustand SOC, der einem Mittelwert aus den Ladezuständen SOC1, SOC2 der beiden Batteriezellen 21-x (Fig. 1) entspricht. Durch beispielsweise eine höhere Temperatur in der Batteriezelle 21-2 im Vergleich zur Batteriezelle 21-1 hat die Batteriezelle 21-2 einen geringeren Innenwiderstand. Als Folge teilt sich der (Gesamt-)Ladestrom I in zwei ungleich große Teilströme I1 und I2 auf. Der Ladestrom I2 ist hierbei größer als der Ladestrom I2. Hierdurch steigt ein Ladezustand SOC2 der Batteriezelle 21-2 schneller an als ein Ladezustand SOC1 der Batteriezelle 21-1. Da der Ladezustands-Schätzer 4 (Fig. 1) nur den (Gesamt-)Strom I oder die (Gesamt-)Spannung U der parallelgeschalteten Batteriezellen 21-x erfassen kann, wird nur ein resultierender Mittelwert des Ladezustands SOC aus den Ladezuständen SOC1, SOC2 der Batteriezellen 21-x erfasst. Die Laderegelung durch den Laderegler 2, welche anhand des Ladezustands SOC ausgehend von der ersten ladezustandsabhängigen Kennlinie 3-1 eine maximal zulässige Spannung Ulim freigibt, würde im Falle von Batteriezelle 21-1 eine zu große Spannung (hier Ulim) freigeben. Jedoch würde gemäß dem in dieser Offenbarung beschriebenen Verfahren der Strom I anhand der zweiten ladezustandsabhängigen Kennlinie 3-2 auf den Strom Ilim begrenzt werden, der kleiner ist als Ilim1. Da beide Begrenzungen bei der Regelung berücksichtigt werden, würde es im Ergebnis weder zu einer Stromgrenzenverletzung, noch zu einer Spannungsgrenzenverletzung kommen. Eine Regelung mit einer einzigen Kennlinie, beispielsweise nur der ersten ladezustandsabhängigen Kennlinie 3-1, hätte hingegen zum Überschreiten der maximalen Spannung bei der Batteriezelle 21-1 geführt. Im Falle der Batteriezelle 21-2 würde zunächst ein zu großer Wert für die Strombegrenzung (Ilim statt Ilim2) angenommen werden, jedoch ist der Wert für die Spannungsbegrenzung Ulim kleiner als Ulim2, wodurch der resultierende Strom I ebenfalls begrenzt wird. Da beide Begrenzungen bei der Regelung berücksichtigt werden, würde es im Ergebnis daher weder zu einer Stromgrenzenverletzung, noch zu einer Spannungsgrenzenverletzung kommen. Eine Regelung mit einer einzigen Kennlinie, beispielsweise nur der zweiten ladezustandsabhängigen Kennlinie 3-2, hätte hingegen zum Überschreiten des maximalen Stroms bei der Batteriezelle 21-2 geführt.

In der Fig. 2b schätzt der Ladezustands-Schätzer 4 (Fig. 1) durch einen Fehler einen Ladezustand SOC, der größer ist als der Mittelwert SOC aus den Ladezuständen SOC1, SOC2 der beiden Batteriezellen 3-x. Die Laderegelung, welche anhand des Ladezustands SOC eine maximale Spannung U freigibt, würde im Falle von Batteriezelle 3-1 und Batteriezelle 3-2 eine zu große Spannung Ulim freigeben. Jedoch wird verfahrensgemäß durch die zweite ladezustandsabhängige Kennlinie 3-2 der Strom auf Ilim beschränkt, sodass der Wert kleiner ist als Ilim1 und Ilim2. Da beide Begrenzungen bei der Regelung berücksichtigt werden, würde es im Ergebnis daher weder zu einer Stromgrenzenverletzung, noch zu einer Spannungsgrenzenverletzung kommen. Eine Regelung mit einer einzigen Kennlinie, beispielsweise nur der ersten ladezustandsabhängigen Kennlinie 3-1, hätte hingegen zum Überschreiten der maximalen Spannung bei beiden Batteriezellen 21-1, 21-2 geführt.

In der Fig. 2c schätzt der Ladezustands-Schätzer 4 (Fig. 1) einen Ladezustand SOC, der kleiner ist als der Mittelwert aus den Ladezuständen SOC1, SOC2 der beiden Batteriezellen 3-x. Die Laderegelung würde zunächst einen zu großen Wert für die Strombegrenzung annehmen (Ilim statt Ilim1 und Ilim2). Verfahrensgemäß ist aber der Wert der Spannungsbegrenzung Ulim kleiner als Ulim1 und Ulim2, wodurch der resultierende Strom I beim Laden auch begrenzt wird. Da beide Begrenzungen bei der Regelung berücksichtigt werden, würde es im Ergebnis daher weder zu einer Stromgrenzenverletzung, noch zu einer Spannungsgrenzenverletzung kommen. Eine Regelung mit einer einzigen Kennlinie, beispielsweise nur der zweiten ladezustandsabhängigen Kennlinie 3-2, hätte hingegen zum Überschreiten des maximalen Stroms bei beiden Batteriezellen 21-1, 21-2 geführt.

Die gezeigten Szenarien sind lediglich beispielhafter Natur und dienen der Verdeutlichung des in dieser Offenbarung beschriebenen Verfahrens und der Vorrichtung. Grundsätzlich können die Kennlinien 3-x auch andere Größen abbilden und/oder einen anderen Verlauf aufweisen.

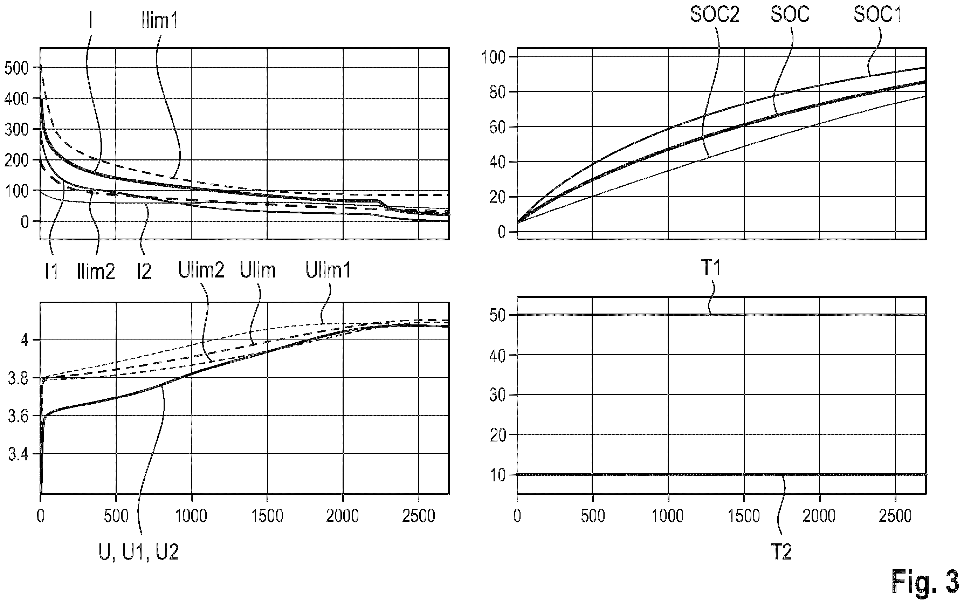

Die Fig. 3 zeigt Ergebnisse eines simulierten Ladevorgangs an einem Batteriesystem mit zwei parallel geschalteten Batteriezellen, wie dies in Fig. 1 schematisch dargestellt ist, und einer verfahrensgemäßen Regelung. Die eine Batteriezelle hat hierbei eine Temperatur von 10°C, die andere eine Temperatur von 50°C. Die verwendeten Simulationsparameter sind hierbei die folgenden:
- Zellchemie: NMC
- Zellkapazität: 100 Ah
- Wärmekapazität einer Zelle: 2000 J/K
- Isotherme Randbedingungen
- Wärmeaustauschkoeffizient zwischen den parallelgeschalteten Zellen: 0 W/K
- Startladezustand zu Beginn der Simulation: 5 % (von der maximalen Ladungsmenge)
- Widerstand der Verbindungselemente der parallelgeschalteten Zellen: 0 Ohm
- Kontaktwiderstände: 0 Ohm
- Zellinnenwiderstand bei 10°C: 1 mOhm bis 3 mOhm
- Zellinnenwiderstand bei 50°C: 0,5 mOhm bis 1,5 mOhm
- erste ladezustandsabhängige Kennlinie gibt die maximale Spannung Ulim vor (Grenzspannung)
- zweite ladezustandsabhängige Kennlinie gibt den maximalen Strom Ilim vor (Grenzstrom)

In der Fig. 3 oben links sind ein (Gesamt-)Strom I, die jeweiligen maximalen Ströme Ilim1, Ilim2 und die Ströme I1, I2 der Batteriezellen, jeweils in A gezeigt; oben rechts sind der (Gesamt-)Ladezustand SOC sowie die Ladezustände SOC1 und SOC2 der Batteriezellen in % gezeigt; unten links sind eine (Gesamt-)Spannung U, eine jeweilige Spannung U1, U2 an den Batteriezellen sowie eine maximale Spannung Ulim (Grenzspannung) und die maximalen Spannungen Ulim1 und Ulim2, welche sich ausgehend von SOC1 bzw. SOC2 ergeben, jeweils in V, gezeigt und unten rechts ist eine Temperatur T1, T2 der beiden Batteriezellen in °C gezeigt. Die Größen sind jeweils über der Zeitachse mit der Einheit Sekunden gezeigt.

Es wird angemerkt, dass für die Regelung insbesondere nur Ulim, I und SOC sowie die Temperaturen verwendet werden. Insbesondere I1, I2, Ulim1, Ulim2, SOC1 und SOC2 sind in der Realität unbekannt und dienen im Rahmen der Simulation nur zur Veranschaulichung des in dieser Offenbarung beschriebenen Verfahrens.

Es ist deutlich zu erkennen, dass die Ströme I1, I2 durch die verfahrensgemäße Regelung stets unter dem jeweils relevanten maximalen Strom Ilim1, Ilim2 bleiben. Auch die Spannungen U1, U2 bleiben stets unter der maximalen Spannung Ulim.

### Bezugszeichenliste

- 1: Vorrichtung
- 2: Regler
- 3-1: erste ladezustandsabhängige Kennlinie
- 3-2: zweite ladezustandsabhängige Kennlinie
- 4: Ladezustand-Schätzer
- 20: Batteriesystem
- 21-x: Batteriezelle
- I: Strom
- I1: Strom (erste Batteriezelle)
- I2: Strom (zweite Batteriezelle)
- Ilim: maximaler Strom
- Ilim1: maximaler Strom (ausgehend von SOC1)
- Ilim2: maximaler Strom (ausgehend von SOC2)
- P: Leistung
- P1: Leistung (erste Batteriezelle)
- P2: Leistung (zweite Batteriezelle)
- SOC: (Gesamt-)Ladezustand
- SOC1: Ladezustand (erste Batteriezelle)
- SOC2: Ladezustand (zweite Batteriezelle)
- T: Temperatur
- U: (Gesamt-)Spannung
- U1: Spannung (erste Batteriezelle)
- U2: Spannung (zweite Batteriezelle)
- Ulim: maximale Spannung
- Ulim1: maximale Spannung (ausgehend von SOC1)
- Ulim2: maximale Spannung (ausgehend von SOC2)

## Patentansprüche

1. Verfahren zum Laden oder Entladen eines Batteriesystems (20),
wobei das Batteriesystem (20) mindestens zwei parallel und/oder in Reihe geschaltete Batteriezellen (21-x) aufweist, welche nur gemeinsam geladen oder entladen werden können,
wobei eine Spannung (U) als Regelgröße mittels eines Stroms (I) oder einer Leistung (P) als Stellgröße geregelt wird, wobei hierbei der Strom (I) oder die Leistung (P) unter Berücksichtigung von einer ersten ladezustandsabhängigen Kennlinie (3-1) und einer zweiten ladezustandsabhängigen Kennlinie (3-2) vorgegeben wird, und
wobei die erste ladezustandsabhängige Kennlinie (3-1) und die zweite ladezustandsabhängige Kennlinie (3-2) zumindest abschnittsweise entgegengesetzte Steigungen aufweisen.

2. Verfahren nach Anspruch 1, **dadurch gekennzeichnet, dass** die Kennlinien (3-x) über alle Ladezustände (SOC) hinweg entgegengesetzte Steigungen aufweisen.

3. Verfahren nach Anspruch 1 oder 2, **dadurch gekennzeichnet, dass** die erste ladezustandsabhängige Kennlinie (3-1) eine mit dem Ladezustand (SOC) ansteigende Maximalspannung (Ulim) beim Laden oder Entladen vorgibt.

4. Verfahren nach Anspruch 1 oder 2, **dadurch gekennzeichnet, dass** die erste ladezustandsabhängige Kennlinie (3-1) einen mit dem Ladezustand(SOC) ansteigenden maximalen Innenwiderstand beim Laden oder Entladen vorgibt.

5. Verfahren nach einem der vorangegangenen Ansprüche, **dadurch gekennzeichnet, dass** die zweite ladezustandsabhängige Kennlinie (3-2) einen mit dem Ladezustand (SOC) fallenden maximalen Strom (Ilim) beim Laden oder Entladen vorgibt.

6. Verfahren nach einem der Ansprüche 1 bis 4, **dadurch gekennzeichnet, dass** die zweite ladezustandsabhängige Kennlinie (3-2) eine mit dem Ladezustand (SOC) fallende maximale Leistung beim Laden oder Entladen vorgibt.

7. Verfahren nach einem der vorangegangenen Ansprüche, **dadurch gekennzeichnet, dass** eine Temperatur(T) des Batteriesystems erfasst und/oder geschätzt wird, wobei die erste ladezustandsabhängige Kennlinie (3-1) und/oder die zweite ladezustandsabhängige Kennlinie (3-2) temperaturabhängig sind, und wobei die erfasste und/oder geschätzte Temperatur (T) berücksichtigt wird.

8. Verfahren nach einem der vorangegangenen Ansprüche, **dadurch gekennzeichnet, dass** ein Ladezustand (SOC) des Batteriesystems (20) ausgehend von einer zeitlichen Integration des Stromes (I) beim Laden oder Entladen geschätzt wird.

9. Verfahren nach einem der vorangegangenen Ansprüche, **dadurch gekennzeichnet, dass** ein Ladezustand (SOC) des Batteriesystems (20) ausgehend von einer Leerlaufspannungs-Ladezustands-(OCV/SOC)-Kennlinie und/oder mittels eines elektrischen Batteriemodells geschätzt wird.

10. Vorrichtung (1) zum Laden oder Entladen eines Batteriesystems (20),
wobei das Batteriesystem (20) mindestens zwei parallel und/oder in Reihe geschaltete Batteriezellen (21-x) aufweist, welche nur gemeinsam geladen oder entladen werden können, umfassend:
einen Regler (2), wobei der Regler (2) dazu eingerichtet ist, eine Spannung (U) als Regelgröße mittels eines Stroms (I) oder einer Leistung (P) als Stellgröße zu regeln,
wobei hierbei der Strom (I) oder die Leistung (P) unter Berücksichtigung von einer ersten ladezustandsabhängigen Kennlinie (3-1) und einer zweiten ladezustandsabhängigen Kennlinie (3-2) vorgegeben wird, und
wobei die erste ladezustandsabhängige Kennlinie (3-1) und die zweite ladezustandsabhängige Kennlinie (3-2) zumindest abschnittsweise entgegengesetzte Steigungen aufweisen.

11. Verfahren zum Laden oder Entladen eines Batteriesystems (20),
wobei das Batteriesystem (20) eine Batteriezelle (21-x) aufweist,
wobei eine Spannung (U) als Regelgröße mittels eines Stroms (I) oder einer Leistung (P) als Stellgröße geregelt wird, wobei hierbei der Strom (I) oder die Leistung (P) unter Berücksichtigung von einer ersten ladezustandsabhängigen Kennlinie (3-1) und einer zweiten ladezustandsabhängigen Kennlinie (3-2) vorgegeben wird, und
wobei die erste ladezustandsabhängige Kennlinie (3-1) und die zweite ladezustandsabhängige Kennlinie (3-2) zumindest abschnittsweise entgegengesetzte Steigungen aufweisen.

12. Vorrichtung (1) zum Laden oder Entladen eines Batteriesystems (20),
wobei das Batteriesystem (20) eine Batteriezelle (21-x) aufweist, umfassend:
einen Regler (2), wobei der Regler (2) dazu eingerichtet ist, eine Spannung (U) als Regelgröße mittels eines Stroms (I) oder einer Leistung (P) als Stellgröße zu regeln,
wobei hierbei der Strom (I) oder die Leistung (P) unter Berücksichtigung von einer ersten ladezustandsabhängigen Kennlinie (3-1) und einer zweiten ladezustandsabhängigen Kennlinie (3-2) vorgegeben wird, und
wobei die erste ladezustandsabhängige Kennlinie (3-1) und die zweite ladezustandsabhängige Kennlinie (3-2) zumindest abschnittsweise entgegengesetzte Steigungen aufweisen.
